# EUROPÄISCHE PATENTANMELDUNG

(11) **EP 1 263 023 A1**
(43) Veröffentlichungstag der Anmeldung: **04.12.2002**
(21) Anmeldenummer: 01113466.5
(22) Anmeldetag: 02.06.2001
(51) Int. Cl.: H01L 21/00

(54) **Vorrichtung zum einseitigen Behandeln eines scheibenförmigen Werkstückes**

(71) Anmelder: silicet AG, 34253 Lohfelden (DE)
(72) Erfinder: Moritz, Hans, 34253 Lohfelden (DE)
(74) Vertreter: Masch, Karl Gerhard, Dr.

(57) **Zusammenfassung**

Eine Vorrichtung zum einseitigen Behandeln eines scheibenförmigen Werkstückes (4) mit einer Behandlungsflüssigkeit, insbesondere zum einseitigen Ätzen einer Halbleiterscheibe (4) nach Art einer Ätzdose, bestehend aus einem plattenförmigen Grundkörper (1) mit einer Zentralöffnung (2), die kleiner als das scheibenförmige Werkstück (4) ist, und aus einem die Zentralöffnung (2) auf einer Seite des Grundkörpers (1) verschließenden Deckel (3). Das scheibenförmige Werkstück (4) ist mit Hilfe einer Dichtungsanordnung (5) aus zwei mit Abstand voneinander konzentrisch um die Zentralöffnung (2) herum angeordneten elastischen Dichtungen (6), zwischen denen eine Unterdruckleitung (7) mündet, am Grundkörper (1) haltbar. Bei einer derartigen Vorrichtung ist eine sichere Abdichtung durch die Dichtungsanordnung (5) gegeben, wenn die beiden Dichtungen (6) im Querschnitt gesehen jeweils in einer Doppelspitze (8) mit zwischenliegender Verformbarkeitsnut (9) auslaufen.

Zu veröffentlichen mit der einzigen Zeichnungsfigur.

## Beschreibung

Die Erfindung betrifft eine Vorrichtung zum einseitigen Behandeln eines scheibenförmigen Werkstückes mit einer Behandlungsflüssigkeit, insbesondere zum einseitigen Ätzen einer Halbleiterscheibe bzw. eines Wavers nach Art einer Ätzdose, bestehend aus einem plattenförmigen Grundkörper mit einer Zentralöffnung, die kleiner als das scheibenförmige Werkstück ist, und aus einem die Zentralöffnung auf einer Seite des Grundkörpers verschließenden Deckel, wobei das scheibenförmige Werkstück mit Hilfe einer Dichtungsanordnung aus zwei mit Abstand voneinander konzentrisch um die Zentralöffnung herum angeordneten elastischen Dichtungen, zwischen denen eine Unterdruckleitung mündet, am Grundkörper haltbar ist.

Neben dem Ätzen kann das Behandeln mit der Behandlungsflüssigkeit z. B. aus einem Galvanisieren bestehen.

Bei bekannten Vorrichtungen der genannten Art (DE 199 22 498 A1) bestehen die beiden Dichtungen im Querschnitt gesehen jeweils aus einer nach innen bzw. außen gewinkelten Einzelspitze. Das Halten des Werkstückes ist mit einer solchen Dichtungsanordnung sicher durchzuführen, Probleme bestehen jedoch bezüglich der Dichtheit. Tatsächlich beobachtet man im Bereich der Dichtungsanordnung Durchtritte der Behandlungsflüssigkeit bzw. Ablagerungen von Behandlungsflüssigkeitsausscheidungen. Hierdurch wird beispielsweise die später nutzbare Fläche des plattenförmigen Grundkörpers bzw. Wavers reduziert.

Der Erfindung liegt die Aufgabe zugrunde, eine Vorrichtung der eingangs genannten Art so auszubilden, dass neben einem sicheren Halten auch eine sichere Abdichtung gewährleistet ist.

Die erfindungsgemäße Lösung dieser Aufgabe besteht darin, dass die beiden Dichtungen im Querschnitt gesehen, jeweils in einer Doppelspitze mit zwischenliegender Verformbarkeitsnut auslaufen.

Überraschenderweise zeigen die mit den Doppelspitzen versehenen Dichtungen eine absolut sichere Abdichtung gegenüber der jeweiligen Behandlungsflüssigkeit, so dass die beschriebenen Beschränkungen entfallen.

Für die weitere Ausführung bestehen im Rahmen der Erfindung mehrere Möglichkeiten. So hat sich eine Ausführungsform bewährt, bei der die Doppelspitzen mit der zwischenliegenden Verformbarkeitsnut jeweils eine M-förmige Gestalt aufweisen. Im Übrigen empfiehlt es sich, den Grundkörper und die Dichtungsanordnung einstückig aus einem elastischen Material herzustellen.

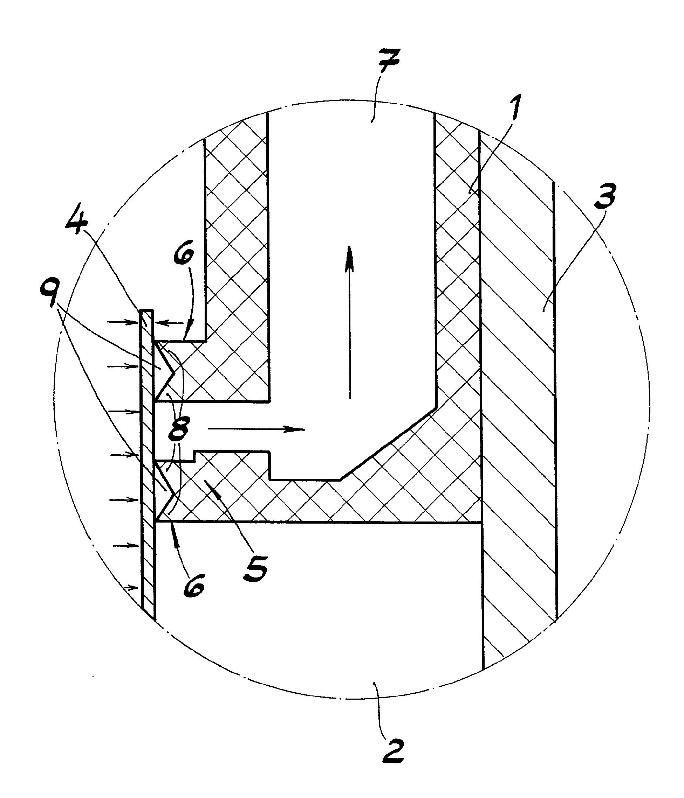

Im Folgenden wird die Erfindung anhand einer ein Ausführungsbeispiel darstellenden Zeichnung näher erläutert, deren einzige Figur einen Querschnitt durch einen Teil einer Vorrichtung zeigt.

Die in den Figuren dargestellte Vorrichtung dient zum einseitigen Ätzen eines Wavers nach Art einer Ätzdose.

In ihrem grundsätzlichen Aufbau besteht die Vorrichtung aus einem plattenförmigen Grundkörper 1 mit einer Zentralöffnung 2 und aus einem die Zentralöffnung 2 auf einer Seite des Grundkörpers 1 verschließenden Deckel 3. Die Zentralöffnung 2 ist kleiner als der Waver 4. Der Waver 4 wird mit Hilfe einer Dichtungsanordnung 5 aus zwei mit Abstand voneinander konzentrisch um die Zentralöffnung 2 herum angeordneten elastischen Dichtungen 6 am Grundkörper 1 gehalten, zwischen denen eine Unterdruckleitung 7 mündet.

Wie man aus der Figur unschwer erkennt, laufen die beiden Dichtungen 6 im Querschnitt gesehen jeweils in einer Doppelspitze 8 mit zwischenliegender Verformbarkeitsnut 9 aus. Im Ausführungsbeispiel weisen die Doppelspitzen 8 mit der zwischenliegenden Verformbarkeitsnut 9 jeweils eine M-förmige Gestalt auf. Im Übrigen erkennt man in der Figur, dass der Grundkörper 1 und die Dichtungsanordnung 5 einstückig aus einem elastischen Material hergestellt sind.

## Patentansprüche

1. Vorrichtung zum einseitigen Behandeln eines scheibenförmigen Werkstückes (4) mit einer Behandlungsflüssigkeit, insbesondere einseitigen Ätzen einer Halbleiterscheibe (Waver) nach Art einer Ätzdose, bestehend aus einem plattenförmigen Grundkörper (1) mit einer Zentralöffnung (2), die kleiner als das scheibenförmige Werkstück (4) ist, und aus einem die Zentralöffnung (2) auf einer Seite des Grundkörpers (1) verschließenden Deckel (3), wobei das scheibenförmige Werkstück (4) mit Hilfe einer Dichtungsanordnung (5) aus zwei mit Abstand voneinander konzentrisch um die Zentralöffnung (2) herum angeordneten elastischen Dichtungen (6), zwischen denen eine Unterdruckleitung (7) mündet, am Grundkörper (1) haltbar ist, **dadurch gekennzeichnet,dass** die beiden Dichtungen (6) im Querschnitt gesehen jeweils in einer Doppelspitze (8) mit zwischenliegender Verformbarkeitsnut (9) auslaufen.

2. Verfahren nach Anspruch 1, **dadurch gekennzeichnet, dass** die Doppelspitzen (8) mit der zwischenliegenden Verformbarkeitsnut (9) jeweils eine M-förmige Gestalt aufweisen.

3. Verfahren nach einem der Ansprüche 1 oder 2, **dadurch gekennzeichnet, dass** der Grundkörper (1) und die Dichtungsanordnung (5) einstückig aus einem elastischen Material hergestellt sind.
